(19)

Europäisches
Patentamt

European
Patent Office

Office européen
des brevets

(11) **EP 4 749 306 A1**

(12) **EUROPEAN PATENT APPLICATION**
published in accordance with Art. 153(4) EPC

(43) Date of publication:
**27.05.2026  Bulletin 2026/22**

(21) Application number: **25823737.9**

(22) Date of filing: **28.04.2025**

(51) International Patent Classification (IPC):
*G01R 31/389* (2019.01)      *G01R 31/385* (2019.01)
*G01R 31/387* (2019.01)      *G01R 31/396* (2019.01)

(86) International application number:
**PCT/CN2025/091709**

(87) International publication number:
**WO 2026/011899 (15.01.2026 Gazette 2026/03)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority:  **10.07.2024   CN 202410916895**

(71) Applicant: **IBATTERYCLOUD CO., LTD.**
**Yantai, Shandong 264000 (CN)**

(72) Inventors:
• **CI, Song**
  **Yantai, Shandong 264004 (CN)**
• **ZHANG, Ming**
  **Yantai, Shandong 264004 (CN)**

• **LI, Chaofan**
  **Yantai, Shandong 264004 (CN)**
• **LI, Kai**
  **Yantai, Shandong 264004 (CN)**
• **WANG, Yunfang**
  **Yantai, Shandong 264004 (CN)**
• **LI, Xuefeng**
  **Yantai, Shandong 264004 (CN)**
• **BAI, Xuheng**
  **Yantai, Shandong 264004 (CN)**
• **GAO, Hong**
  **Yantai, Shandong 264004 (CN)**

(74) Representative: **Chung, Hoi Kan**
**Mandarin IP Limited**
**7 Cherry Trees**
**Great Shelford**
**Cambridge CB22 5XA (GB)**

(54) **INTERNAL RESISTANCE CONSISTENCY EVALUATION METHOD FOR DYNAMIC RECONFIGURABLE BATTERY MODULE, AND SYSTEM**

(57)     Disclosed are an internal resistance consistency evaluation method and system for a dynamically reconfigurable battery module in the technical field of energy storage in power systems, where the method includes: calculating a current change rate by introducing a nominal capacity of battery cells; selecting a previous sampling time point of a sampling time point at which the current change rate is greater than or equal to a target current change rate as a target sampling time point; when the number of the target sampling time points is greater than a preset value, calculating an internal resistance of each of the battery cells at the target sampling time points according to the target sampling time points, and constructing an internal resistance matrix; and utilizing the internal resistance matrix and applying an improved internal resistance consistency evaluation algorithm to calculate and obtain an internal resistance consistency result of the dynamically reconfigurable battery module. By introducing the nominal capacity of the battery cells to calculate the current change rate, and screening the sampling time points, the present application improves the versatility of internal resistance consistency evaluation across batteries of different specifications and, by introducing the improved algorithm based on the transformation coefficient, enhances the characterization capability of internal resistance consistency evaluation.

EP 4 749 306 A1

S1

Acquire currents of the dynamically reconfigurable energy storage battery module at different sampling time points, and voltages of the battery cells at different sampling time points

S2

Calculate a current change rate at different sampling time points by using the currents of the dynamically reconfigurable energy storage battery module at different sampling time points

S3

Select a previous sampling time point of a sampling time point at which the current change rate is greater than or equal to a target current change rate as a target sampling time point

S4

When the number of the target sampling time points is greater than a preset value, calculate an internal resistance of each of the battery cells at the target sampling time points according to the target sampling time points, and construct an internal resistance matrix

S5

Utilize the internal resistance matrix and apply an improved internal resistance consistency evaluation algorithm to calculate and obtain an internal resistance consistency result of the dynamically reconfigurable battery module

FIG. 1

**Description**

TECHNICAL FIELD

The present application relates to the technical field of energy storage in power systems and, in particular, to an internal resistance consistency evaluation method and system for a dynamically reconfigurable battery module.

BACKGROUND

With the continuous expansion of renewable energy power generation installation scale, the proportion of renewable energy power generation in the power grid is increasing. However, due to the small unit capacity, large quantity, dispersed distribution, and significant intermittency, volatility, and randomness of renewable energy power generation, a high proportion of renewable energy grid integration is bound to bring unprecedented challenges to the power system's supply-demand balance, security, stability control, and other aspects. Energy storage systems are a critical link in regulating the supply-demand imbalance between renewable energy power generation and the power system, as well as in energy management and optimization. A dynamically reconfigurable battery energy storage system breaks the conventional application mode of fixed series and parallel connections of batteries by employing program-controlled flexible connections, fundamentally solving the "short-board effect" of battery systems. It achieves fine-grained integrated management and control of electrical and thermal aspects of battery systems and a system-level intrinsic safety mechanism. Dynamically reconfigurable battery energy storage technology provides a novel technical path for constructing large-scale, high-safety, long-life, and low-cost battery energy storage systems, representing the future development direction of the energy storage industry. The internal resistance of lithium batteries is influenced by many factors, such as external factors like temperature, current, and load, as well as internal factors including battery material properties, structure, manufacturing process, and aging. By evaluating the internal resistance consistency of battery modules in an energy storage system, the inconsistencies between different battery cells can be understood, allowing for timely detection and handling of inconsistent cells, thereby improving the operational efficiency and safety of the energy storage system.

In some cases, the evaluation of internal resistance consistency in dynamically reconfigurable battery energy storage systems has the following shortcomings: 1. poor versatility

-   the internal resistance consistency evaluation method only uses absolute current differences to determine the target sampling time point, making it unable to adapt to battery modules of different models and specifications; in addition, different application scenarios require adjustments to parameter thresholds, resulting in poor versatility and accuracy; 2. poor characterization capability

-   the interpretability of internal resistance consistency is weak, making it unable to accurately characterize the true internal resistance consistency results.

SUMMARY

The present application aims to provide an internal resistance consistency evaluation method for a dynamically reconfigurable battery module, which can improve the versatility of internal resistance consistency evaluation across batteries of different specifications and enhance the characterization capability of the internal resistance consistency evaluation through algorithm improvements.

To achieve the aforementioned objectives, the present application provides the following solutions:

in a first aspect, the present application provides an internal resistance consistency evaluation method for a dynamically reconfigurable battery module, where the dynamically reconfigurable battery module includes a plurality of battery cells connected in series sequentially, and the method includes the following steps: acquiring currents of the dynamically reconfigurable energy storage battery module at different sampling time points, and voltages of the battery cells at different sampling time points; calculating a current change rate at different sampling time points by using the currents of the dynamically reconfigurable energy storage battery module at different sampling time points, where the current change rate is an absolute value of a ratio of a current difference between two adjacent sampling time points to a nominal capacity of the battery cells; selecting a previous sampling time point of a sampling time point at which the current change rate is greater than or equal to a target current change rate as a target sampling time point; when the number of the target sampling time points is greater than a preset value, calculating an internal resistance of each of the battery cells at the target sampling time points according to the target sampling time points, and constructing an internal resistance matrix; and utilizing the internal resistance matrix and applying an improved internal resistance consistency evaluation algorithm to calculate and obtain an internal resistance consistency result of the dynamically reconfigurable battery module, where the improved internal resistance consistency evaluation algorithm is constructed based on an internal resistance consistency transformation coefficient.

In a second aspect, the present application provides a computer system, including: a memory, a processor, and a computer program stored on the memory and executable on the processor, where the processor executes the computer program to implement the steps of the internal resistance consistency evaluation method for the dynamically reconfigurable battery module described above.

Based on specific embodiments provided in the present application, the following technical effects are disclosed: the present application provides an internal resistance consistency evaluation method and system for a dynamically reconfigurable battery module. By introducing the nominal capacity of the battery cells to calculate the current change rate, and selecting the previous sampling time point of the sampling time point where the current change rate is greater than or equal to the target current change rate as the target sampling time point, the method solves the problem that conventional internal resistance consistency evaluation methods only use absolute current differences to determine target sampling time points, which cannot adapt to battery modules of different models and specifications. This improves the versatility of internal resistance consistency evaluation across batteries of different specifications. Furthermore, by introducing the improved algorithm based on the transformation coefficient, the characterization capability and interpretability of internal resistance consistency evaluation are improved.

BRIEF DESCRIPTION OF THE DRAWINGS

To describe the technical solutions in the embodiments of the present application or in the prior art more clearly, the following will briefly introduce the accompanying drawings required for describing the embodiments. Apparently, the accompanying drawings in the following description show merely some embodiments of the present application, and a person of ordinary skill in the art may still derive other accompanying drawings from these accompanying drawings without creative efforts.

FIG. 1 is a schematic flowchart of an internal resistance consistency evaluation method for a dynamically reconfigurable battery module according to an embodiment of the present application;
FIG. 2 is a voltage curve graph of battery cells at different sampling time points according to an embodiment of the present application;
FIG. 3 is a current curve graph of a dynamically reconfigurable energy storage battery module at different sampling time points according to an embodiment of the present application;
FIG. 4 is an internal resistance curve graph of battery cells at different sampling time points according to an embodiment of the present application;
FIG. 5 is a histogram of voltage consistency evaluation results for different dynamically reconfigurable battery modules according to an embodiment of the present application; and
FIG. 6 is a schematic structural diagram of a computer system according to an embodiment of the present application.

DETAILED DESCRIPTION OF THE EMBODIMENTS

The technical solutions in the embodiments of the present application will be clearly and completely described below with reference to the accompanying drawings in the embodiments of the present application. Apparently, the described embodiments are only some rather than all of the embodiments of the present application. All other embodiments obtained by a person of ordinary skill in the art based on the embodiments of the present application without creative efforts shall fall within the protection scope of the present application.

To make the aforementioned objectives, features, and advantages of the present application more comprehensible, a detailed explanation of the present application will be given below with reference to the accompanying drawings and specific implementation manners.

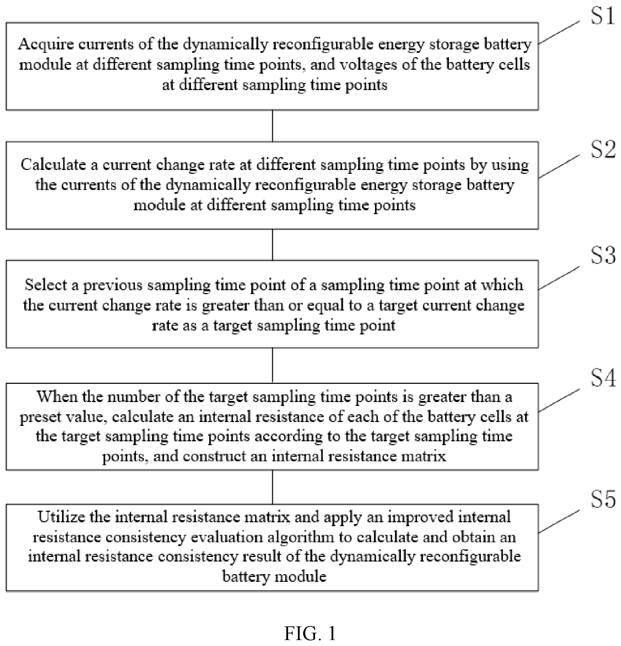

Example 1: as shown in FIG. 1, this example provides an internal resistance consistency evaluation method for a dynamically reconfigurable battery module, where the dynamically reconfigurable battery module includes a plurality of battery cells connected in series sequentially, and the method includes the following steps.

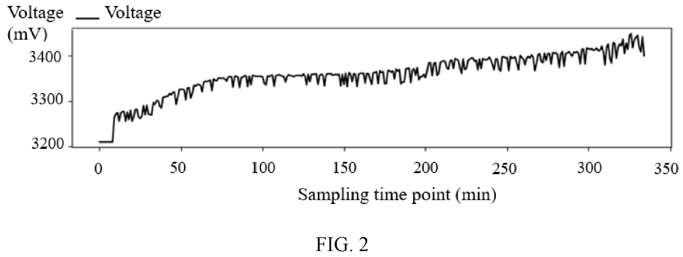

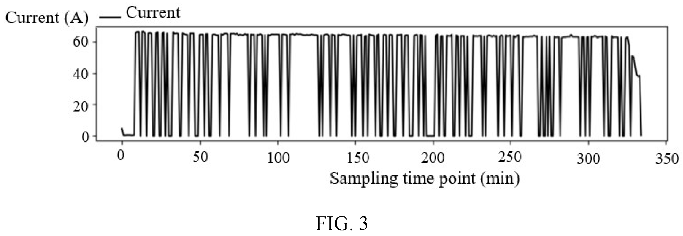

S1: as shown in FIGs. 2-3, acquiring currents of the dynamically reconfigurable energy storage battery module at different sampling time points, and voltages of the battery cells at different sampling time points.

In practical applications, the currents of the dynamically reconfigurable energy storage battery module at different sampling time points and the voltages of the battery cells at different sampling time points can be acquired from input operational data of the dynamically reconfigurable energy storage battery module. Subsequently, a current vector is constructed from the currents of the dynamically reconfigurable energy storage battery module at different sampling time points; and a voltage matrix is constructed from the voltages of the battery cells at different sampling time points.

The current vector $I = (I_1, I_2, \cdots, I_m)$ is a 1-row by $m$-column vector, with $m$ being a latest sampling time point; $I_i$ represents a current value $1 \leq i \leq m$ of the dynamically reconfigurable battery module at an $i^{th}$ sampling time point; the voltage matrix $V =$

$$\begin{bmatrix} V_{11} & \cdots & V_{1j} & \cdots & V_{1n} \\ \vdots & \ddots & \vdots & \ddots & \vdots \\ V_{i1} & \cdots & V_{ij} & \cdots & V_{in} \\ \vdots & \ddots & \vdots & \ddots & \vdots \\ V_{m1} & \cdots & V_{mj} & \cdots & V_{mn} \end{bmatrix}$$ is an $m$-row by $n$-

column matrix, where $V_{ij}$ represents a voltage of a $j^{th}$ battery cell at the $i^{th}$ sampling time point; $1 \leq i \leq m$; and $1 \leq j \leq n$.

S2: calculating a current change rate at different sampling time points by using the currents of the dynamically reconfigurable energy storage battery module at different sampling time points, where the current change rate is an absolute value of a ratio of a current difference between two adjacent sampling time points to a nominal capacity of the battery cells.

S3: selecting a previous sampling time point of a sampling time point at which the current change rate is greater than or equal to a target current change rate as a target sampling time point.

The step S3 includes the following steps.

S31: traversing the currents at the sampling time points, and determining whether an $i^{th}$ sampling time point is before a latest sampling time point to obtain a first determination result.

S32: if the first determination result is yes, determining whether an absolute value of a ratio of a current difference between an $(i+1)^{th}$ sampling time point and the $i^{th}$ sampling time point to the nominal capacity of the battery cells is greater than or equal to the target current change rate to obtain a second determination result.

S33: if the second determination result is no, setting $i = i + 1$, and returning to the step of "traversing the currents at the sampling time points, and determining whether the $i^{th}$ sampling time point is before the latest sampling time point".

S34: if the second determination result is yes, outputting the $i^{th}$ sampling time point as the target sampling time point, setting i = i + 1, and returning to the step of "traversing the currents at the sampling time points, and determining whether the $i^{th}$ sampling time point is before the latest sampling time point".

S35: if the first determination result is no, outputting all of the target sampling time points.

Further, the current change rate is calculated by the following formula:

$$Q = \frac{|I_{i+1} - I_i|}{E};$$

where $Q$ represents the current change rate; $I_{i+1}$ represents a current of the dynamically reconfigurable battery module at an $(i+1)^{th}$ target sampling time point; $I_i$ represents a current of the dynamically reconfigurable battery module at an $i^{th}$ target sampling time point; $E$ represents the nominal capacity of the battery cells; and the nominal capacity $E$ of the battery cells is related to the structure of the dynamically reconfigurable energy storage battery module and the battery specifications and model, with the unit being Ah.

In an implementation manner, the target current change rate $\theta$ = 0.1, and for the number of internal resistance sampling time points when the internal resistance consistency result is calculated, a threshold $\rho$ = 20.

$\theta$ and $\rho$ are variable parameters that can be adjusted according to different application scenarios. For example, in a battery module composed of 16 series-connected 280Ah lithium iron phosphate batteries, the value range for $\theta$ may be [0.1,1], and the value range for $\rho$ may be $\geq$ 20.

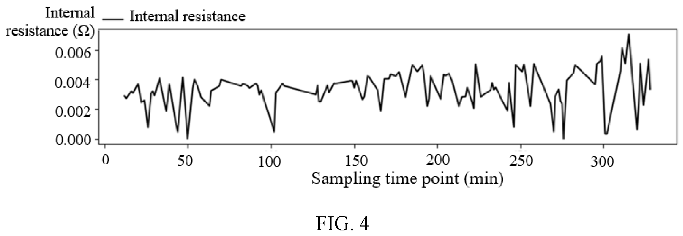

S4: as shown in FIG. 4, when the number of the target sampling time points is greater than a preset value, calculating an internal resistance of each of the battery cells at the target sampling time points according to the target sampling time points, and constructing an internal resistance matrix.

Further, the internal resistance of each of the battery cells at the target sampling time points is calculated by the following formula:

$$R_{ij} = \left| \frac{K_{(i+1)j} - K_{ij}}{I_{i+1} - I_i} \right|;$$

where $R_{ij}$ represents an internal resistance of a $j^{th}$ battery cell at an $i^{th}$ target sampling time point; K represents a target voltage matrix; $K_{(i+1)j}$ represents a voltage of the $j^{th}$ battery cell at an i + $1^{th}$ target sampling time point; $K_{ij}$ represents a voltage of the $j^{th}$ battery cell at the $i^{th}$ target sampling time point; $I$ represents a current vector; $I_{i+1}$ represents a current of the dynamically reconfigurable battery module at the $(i+1)^{th}$ target sampling time point; $I_i$ represents a current of the dynamically reconfigure able battery module at the $i^{th}$ target sampling time point, and $|\cdot|$ represents an absolute value.

In an implementation manner, when the number of the target sampling time points is less than or equal to the preset value, it indicates that the number of the target sampling time points is insufficient, requiring an increase in the number of the battery cells, and the algorithm terminates.

Further, the internal resistance matrix is calculated by the following formula:

$$R = \begin{bmatrix} R_{11} & \cdots & R_{1j} & \cdots & R_{1n} \\ \vdots & \ddots & \vdots & \ddots & \vdots \\ R_{i1} & \cdots & R_{ij} & \cdots & R_{in} \\ \vdots & \ddots & \vdots & \ddots & \vdots \\ R_{k1} & \cdots & R_{kj} & \cdots & R_{kn} \end{bmatrix};$$

where $R$ represents the internal resistance matrix; $R_{11}$ represents an internal resistance of a $1^{st}$ battery cell at a $1^{st}$ target sampling time point; $R_{1j}$ represents an internal resistance of a $j^{th}$ battery cell at the $1^{st}$ target sampling time point; $R_{1n}$ represents an internal resistance of an $n^{th}$ battery cell at the $1^{st}$ target sampling time point; $R_{i1}$ represents an internal resistance of the $1^{st}$ battery cell at an $i^{th}$ target sampling time point; $R_{ij}$ represents an internal resistance of a $j^{th}$ battery cell at the $i^{th}$ target sampling time point; $R_{in}$ represents an internal resistance of the $n^{th}$ battery cell at the $i^{th}$ target sampling time point; $R_{k1}$ represents an internal resistance of the $1^{st}$ battery cell at a $k^{th}$ target sampling time point; $R_{kj}$ represents an internal resistance of the $j^{th}$ battery cell at the $k^{th}$ target sampling time point; and $R_{kn}$ represents an internal resistance of the $n^{th}$ battery cell at the $k^{th}$ target sampling time point.

The step S4 includes the following steps.

S41: selecting currents of the dynamically reconfigurable battery module at the target sampling time points to construct a current vector.

S42: selecting voltages of the battery cells at the target sampling time points to construct a target voltage matrix.

S43: calculating the internal resistance of each of the battery cells at the target sampling time points sequentially according to the current vector and the target voltage matrix, and constructing the internal resistance matrix.

In practical applications, a list composed of the internal resistances of all of the battery cells at the target sampling time points is converted into a *K*-row by *N*-column internal resistance matrix, and then an average internal resistance of each of the battery cells is calculated to construct an average internal resistance vector.

$$\overline{R} = (\overline{R_1}, \cdots, \overline{R_J}, \cdots, \overline{R_n});$$

where $\overline{R_1}$ represents an average internal resistance of a 1st battery cell; $\overline{R_J}$ represents an average internal resistance of a $j$th battery cell; and $\overline{R_n}$ represents an average internal resistance of an $n$th battery cell.

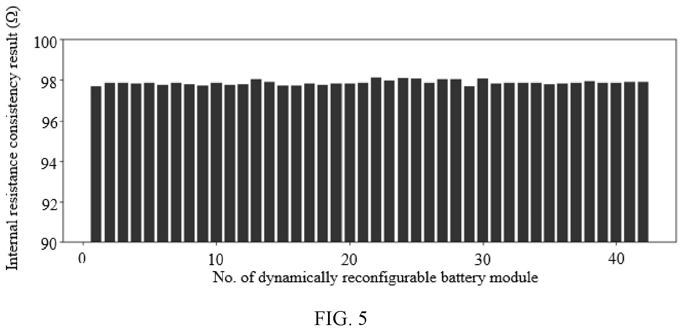

S5: as shown in FIG. 5, utilizing the internal resistance matrix and applying an improved internal resistance consistency evaluation algorithm to calculate and obtain an internal resistance consistency result of the dynamically reconfigurable battery module, where the improved internal resistance consistency evaluation algorithm is constructed based on an internal resistance consistency transformation coefficient.

The step S5 includes the following steps.

S51: utilizing the internal resistance matrix to calculate a mean internal resistance of each of the battery cells.

Further, the mean internal resistance of each of the battery cells is calculated by the following formula:

$$\overline{R_J} = \frac{1}{k}\sum_{i=1}^{k} R_{ij};$$

where $\overline{R_J}$ represents the mean internal resistance of the $j$th battery cell at different sampling time points; and $R_{ij}$ represents an internal resistance of the $j$th battery cell at an $i$th target sampling time point.

S52: applying the improved internal resistance consistency evaluation algorithm to calculate and obtain the internal resistance consistency result of the dynamically reconfigurable battery module according to the mean internal resistance of each of the battery cells by the following formula:

$$S = 100 \times \left(1.5 - \frac{1}{1+e^{-1\cdot\tau cv}}\right);$$

$$cv = \frac{\sigma}{\mu};$$

$$\sigma = \sqrt{\frac{1}{n}\sum_{j=1}^{n}(\overline{R_J} - \mu)^2};$$

$$\mu = \frac{1}{n}\sum_{j=1}^{n}\overline{R_J};$$

where *S* represents the internal resistance consistency result of the dynamically reconfigurable battery module; $\tau$ represents the internal resistance consistency transformation coefficient; *cv* represents a normalized measure of dispersion of a probability distribution of internal resistances of the battery cells for evaluating internal resistance consistency; $\tau$ is used to characterize a penalty applied to the normalized measure *cv* of dispersion of the probability distribution of internal resistances of the battery cells in the internal resistance consistency result; $\sigma$ represents a standard deviation of a mean internal resistance of all of the battery cells; $\mu$ represents the mean internal resistance of all of the battery cells; $\overline{R_J}$ represents a mean internal resistance of a $j$th battery cell; *k* represents the total number of the target sampling time points; and n represents the number of the battery cells.

After obtaining the internal resistance consistency result, the following applications can be implemented:

1) state of health assessment: identifying battery cells with an abnormal internal resistance, predicting battery aging trends, and optimizing maintenance strategies;

2) dynamic reconfiguration optimization: adjusting a module topology (series-parallel switching) in real-time based on internal resistance differences to enhance overall efficiency and energy utilization;

3) balancing management: activating active balancing circuits in a targeted manner to reduce capacity fading caused by internal resistance inconsistencies;

4) safety warning: a sudden increase in internal resistance may indicate a risk of thermal runaway, triggering a battery management system (BMS) protection mechanism; and

5) screening for echelon utilization: rapidly screening batteries with a consistent internal resistance from retired modules to reduce reassembly costs.

In an implementation manner, since the relationship between *cv* and internal resistance consistency is typically non-linear, an internal resistance consistency scoring formula is used to map the *cv* value to a percentage score interval for evaluating internal resistance consistency.

Further, the internal resistance consistency transformation coefficient $\tau \in \{2,4,6\}$, and the internal resistance consistency transformation coefficient $\tau$ can be determined according to the formula $\tau = \left\lfloor \dfrac{n}{4} \right\rfloor$, which represents the number of battery cells in the dynamically reconfigurable battery module divided by 4 and rounded down to the nearest integer.

The present application provides an internal resistance consistency evaluation method and system for a dynamically reconfigurable battery module. By introducing the nominal capacity of the battery cells to calculate the current change rate, and selecting the previous sampling time point of the sampling time point where the current change rate is greater than or equal to the target current change rate as the target sampling time point, the method solves the problem that conventional internal resistance consistency evaluation methods only use absolute current differences to determine target sampling time points, which cannot adapt to battery modules of different models and specifications. This improves the versatility of internal resistance consistency evaluation across batteries of different specifications. Furthermore, by introducing the improved algorithm based on the transformation coefficient, the characterization capability and interpretability of internal resistance consistency evaluation are improved. Furthermore, the present application also ensures the number of internal resistance sampling time points when calculating internal resistance consistency by setting the preset value for the target sampling time points, thereby improving the accuracy and robustness of internal resistance consistency evaluation; enhances the efficiency of internal resistance and internal resistance consistency score calculations through vector-matrix parallel computing; and simultaneously utilizes a pulse charging/discharging mode of the dynamically reconfigurable energy storage system to increase the number of sampling time points for internal resistance calculation, thereby improving the accuracy and robustness of evaluation.

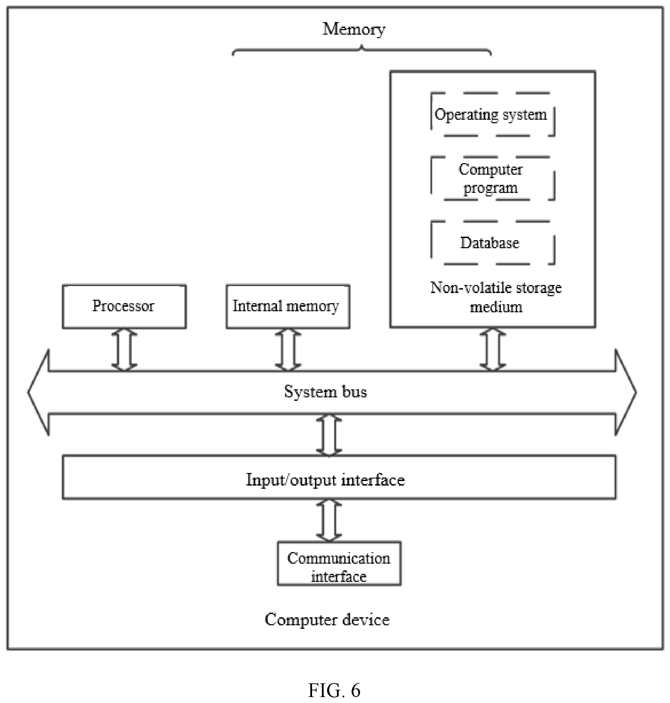

Example 2: this example provides a computer system, which may be a server or a terminal and may have an internal structure shown in FIG. 6. The computer system includes a processor, a memory, an input/output interface (I/O), and a communication interface, where the processor, memory, and input/output interface are connected via a system bus, while the communication interface is connected to the system bus through the input/output interface; the processor is configured to provide computing and control capabilities; the memory includes a non-volatile storage medium and an internal memory, where the non-volatile storage medium stores an operating system, a computer program, and a database, while the internal memory provides an environment for running the operating system and the computer program stored in the non-volatile storage medium; the database is configured to store video tag processing data; the input/output interface is configured to exchange information between the processor and external devices; the communication interface is configured to communicate with external terminals via network connections; and the computer program is executed by the processor to implement an internal resistance consistency evaluation method for a dynamically reconfigurable battery module.

Those skilled in the art can understand that the structure shown in FIG. 6 is only a block diagram of partial structure related to the solution of the present application, and does not constitute a limitation on the computer system to which the solution of the present application is applied. The specific computer system may include more or fewer components than those shown in the figure, or combine some components, or have a different component arrangement.

A person of ordinary skill in the art can understand that all or part of the processes in the above-described method embodiments can be completed by instructing relevant hardware through a computer program, where the computer program can be stored in a non-volatile computer-readable storage medium and can include the processes of the above-described method embodiments when executed. Here, any reference to a memory, database, or any other medium used in the embodiments provided in the present application may include at least one of a non-volatile and a volatile memory. The non-volatile memory may include a read-only memory (ROM), a magnetic tape, a floppy disk, a flash memory, an optical memory, a high-density embedded non-volatile memory, a resistive random-access memory (ReRAM), a magnetoresistive random-access memory (MRAM), a ferroelectric random-access memory (FRAM), a phase-change memory (PCM), or a graphene memory. The volatile memory may include a random-access memory (RAM) or an external cache memory, among others. By way of illustration rather than limitation, the RAM may take various forms, such as a static random-access memory (SRAM) or a dynamic random-access memory (DRAM).

The database involved in the embodiments of the present application may include at least one of a relational database or a non-relational database. The non-relational database may include a distributed database based on a blockchain, or the like, which is not limited thereto. The processor involved in the embodiments of the present application may be a general-purpose processor, a central processing unit, a graphics processor, a digital signal processor, a programmable logic device, a quantum computing-based data processing logic device, or the like, which is not limited thereto.

The technical features of the above embodiments can be combined in any way. To simplify the description, not all possible combinations of the technical features in the above embodiments are described. However, as long as there is no contradiction in the combinations of these technical features, all possible combinations should be considered to fall within the scope of this specification.

Although the embodiments are provided to elaborate the principles and implementation manners of the present application, the descriptions of the aforementioned embodiments are merely intended to help understand the method and core concepts of the present application. Meanwhile, for a person of ordinary skill in the art, variations in specific implementation manners and application scopes may occur based on the concepts of the present application. In conclusion, the content of this specification should not be construed as limiting the present application.

## Claims

1. An internal resistance consistency evaluation method for a dynamically reconfigurable battery module, wherein the dynamically reconfigurable battery module comprises a plurality of battery cells connected in series sequentially, and the internal resistance consistency evaluation method for the dynamically reconfigurable battery module comprises the following steps:

   acquiring currents of the dynamically reconfigurable energy storage battery module at different sampling time points, and voltages of the battery cells at different sampling time points;
   calculating a current change rate at different sampling time points by using the currents of the dynamically reconfigurable energy storage battery module at different sampling time points, wherein the current change rate is an absolute value of a ratio of a current difference between two adjacent sampling time points to a nominal capacity of the battery cells;
   selecting a previous sampling time point of a sampling time point at which the current change rate is greater than or equal to a target current change rate as a target sampling time point;
   when the number of the target sampling time points is greater than a preset value, calculating an internal resistance of each of the battery cells at the target sampling time points according to the target sampling time points, and constructing an internal resistance matrix; and
   utilizing the internal resistance matrix and applying an improved internal resistance consistency evaluation algorithm to calculate and obtain an internal resistance consistency result of the dynamically reconfigurable battery module, wherein the improved internal resistance consistency evaluation algorithm is constructed based on an internal resistance consistency transformation coefficient.

2. The internal resistance consistency evaluation method for the dynamically reconfigurable battery module of claim 1, wherein the step of selecting the previous sampling time point of the sampling time point at which the current change rate is greater than or equal to the target current change rate as the target sampling time point comprises:

   traversing the currents at the sampling time points, and determining whether an $i^{th}$ sampling time point is before a latest sampling time point to obtain a first determination result;
   if the first determination result is yes, determining whether an absolute value of a ratio of a current difference between an $(i+1)^{th}$ sampling time point and the $i^{th}$ sampling time point to the nominal capacity of the battery cells is greater than or equal to the target current change rate to obtain a second determination result;
   if the second determination result is no, setting $i = i + 1$, and returning to the step of "traversing the currents at the sampling time points, and determining whether the $i^{th}$ sampling time point is before the latest sampling time point";
   if the second determination result is yes, outputting the $i^{th}$ sampling time point as the target sampling time point, setting $i = i + 1$, and returning to the step of "traversing the currents at the sampling time points, and determining whether the $i^{th}$ sampling time point is before the latest sampling time point"; and
   if the first determination result is no, outputting all of the target sampling time points.

3. The internal resistance consistency evaluation method for the dynamically reconfigurable battery module of claim 1, wherein the current change rate is calculated by the following formula:

$$Q = \frac{|I_{i+1} - I_i|}{E};$$

   wherein $Q$ represents the current change rate; $I_{i+1}$ represents a current of the dynamically reconfigurable battery module at an $(i+1)^{th}$ target sampling time point; $I_i$ represents a current of the dynamically reconfigurable battery module at an $i^{th}$ target sampling time point; and $E$ represents the nominal capacity of the battery cells.

4. The internal resistance consistency evaluation method for the dynamically reconfigurable battery module of claim 1, wherein the step of calculating the internal resistance of each of the battery cells at the target sampling time points according to the target sampling time points, and constructing the internal resistance matrix comprises:

   selecting currents of the dynamically reconfigurable battery module at the target sampling time points to construct a current vector;
selecting voltages of the battery cells at the target sampling time points to construct a target voltage matrix; and
calculating the internal resistance of each of the battery cells at the target sampling time points sequentially according to the current vector and the target voltage matrix, and constructing the internal resistance matrix.

5. The internal resistance consistency evaluation method for the dynamically reconfigurable battery module of claim 1, wherein the internal resistance of each of the battery cells at the target sampling time points is calculated by the following formula:

$$R_{ij} = \left| \frac{K_{(i+1)j} - K_{ij}}{I_{i+1} - I_i} \right|;$$

wherein $R_{ij}$ represents an internal resistance of a $j$th battery cell at an $i$th target sampling time point; $K$ represents a target voltage matrix; $K_{(i+1)j}$ represents a voltage of the $j$th battery cell at an $i + 1$th target sampling time point; $K_{ij}$ represents a voltage of the $j$th battery cell at the $i$th target sampling time point; $I$ represents a current vector; $I_{i+1}$ represents a current of the dynamically reconfigurable battery module at the $(i+1)$th target sampling time point; $I_i$ represents a current of the dynamically reconfigurable battery module at the $i$th target sampling time point, and $|\cdot|$ represents an absolute value.

6. The internal resistance consistency evaluation method for the dynamically reconfigurable battery module of claim 1, wherein the internal resistance matrix is calculated by the following formula:

$$R = \begin{bmatrix} R_{11} & \cdots & R_{1j} & \cdots & R_{1n} \\ \vdots & \ddots & \vdots & \ddots & \vdots \\ R_{i1} & \cdots & R_{ij} & \cdots & R_{in} \\ \vdots & \ddots & \vdots & \ddots & \vdots \\ R_{k1} & \cdots & R_{kj} & \cdots & R_{kn} \end{bmatrix};$$

wherein $R$ represents the internal resistance matrix; $R_{11}$ represents an internal resistance of a 1st battery cell at a 1st target sampling time point; $R_{1j}$ represents an internal resistance of a $j$th battery cell at the 1st target sampling time point; $R_{1n}$ represents an internal resistance of an $n$th battery cell at the 1st target sampling time point; $R_{i1}$ represents an internal resistance of the 1st battery cell at an $i$th target sampling time point; $R_{ij}$ represents an internal resistance of a $j$th battery cell at the $i$th target sampling time point; $R_{in}$ represents an internal resistance of the $n$th battery cell at the $i$th target sampling time point; $R_{k1}$ represents an internal resistance of the 1st battery cell at a

$k$th target sampling time point; $R_{kj}$ represents an internal resistance of the $j$th battery cell at the $k$th target sampling time point; and $R_{kn}$ represents an internal resistance of the $n$th battery cell at the $k$th target sampling time point.

7. The internal resistance consistency evaluation method for the dynamically reconfigurable battery module of claim 1, wherein the step of utilizing the internal resistance matrix and applying the improved internal resistance consistency evaluation algorithm to calculate and obtain the internal resistance consistency result of the dynamically reconfigurable battery module comprises:

utilizing the internal resistance matrix to calculate a mean internal resistance of each of the battery cells; and
applying the improved internal resistance consistency evaluation algorithm to calculate and obtain the internal resistance consistency result of the dynamically reconfigurable battery module according to the mean internal resistance of each of the battery cells by the following formula:

$$S = 100 \times \left(1.5 - \frac{1}{1 + e^{-1 \cdot \tau \cdot cv}}\right);$$

$$cv = \frac{\sigma}{\mu};$$

$$\sigma = \sqrt{\frac{1}{n} \sum_{j=1}^{n} (\overline{R}_j - \mu)^2};$$

$$\mu = \frac{1}{n} \sum_{j=1}^{n} \overline{R}_j;$$

wherein $S$ represents the internal resistance consistency result of the dynamically reconfigurable battery module; $\tau$ represents the internal resistance consistency transformation coefficient; $cv$ represents a normalized measure of dispersion of a probability distribution of internal resistances of the battery cells for evaluating internal resistance consistency; $\tau$ is used to characterize a penalty applied to the normalized measure $cv$ of dispersion of the probability distribution of internal resistances of the battery cells in the internal resistance consistency result; $\sigma$ represents a standard deviation of a mean internal resistance of all of the battery cells; $\mu$ represents the mean internal resistance of all of the battery cells; $\overline{R}_j$ represents a mean internal resistance of a $j$th battery cell; $k$ represents the total number of the target sampling time points; and n represents the number of the battery cells.

8. The internal resistance consistency evaluation method for the dynamically reconfigurable battery module of claim 7, wherein the mean internal resistance of each of the battery cells is calculated by the following formula:

$$\overline{R_J} = \frac{1}{k}\sum_{i=1}^{k} R_{ij};$$

wherein $\overline{R_J}$ represents the mean internal resistance of the $j^{th}$ battery cell at different sampling time points; and $R_{ij}$ represents an internal resistance of the $j^{th}$ battery cell at an $i^{th}$ target sampling time point.

9. The internal resistance consistency evaluation method for the dynamically reconfigurable battery module of claim 7, wherein the internal resistance consistency transformation coefficient $\tau \in \{2,4,6\}$, and the internal resistance consistency transformation coefficient $\tau$ is determined by the formula

$$\tau = \left\lfloor \frac{n}{4} \right\rfloor.$$

10. A computer system, comprising: a memory, a processor, and a computer program stored on the memory and executable on the processor, wherein the processor executes the computer program to implement the steps of the internal resistance consistency evaluation method for the dynamically reconfigurable battery module of any one of claims 1-9.

Acquire currents of the dynamically reconfigurable energy storage battery module at different sampling time points, and voltages of the battery cells at different sampling time points

S1

Calculate a current change rate at different sampling time points by using the currents of the dynamically reconfigurable energy storage battery module at different sampling time points

S2

Select a previous sampling time point of a sampling time point at which the current change rate is greater than or equal to a target current change rate as a target sampling time point

S3

When the number of the target sampling time points is greater than a preset value, calculate an internal resistance of each of the battery cells at the target sampling time points according to the target sampling time points, and construct an internal resistance matrix

S4

Utilize the internal resistance matrix and apply an improved internal resistance consistency evaluation algorithm to calculate and obtain an internal resistance consistency result of the dynamically reconfigurable battery module

S5

FIG. 1

FIG. 2

FIG. 3

FIG. 4

FIG. 5

FIG. 6

## INTERNATIONAL SEARCH REPORT

| International application No. |
| --- |
| **PCT/CN2025/091709** |

### A. CLASSIFICATION OF SUBJECT MATTER

G01R 31/389(2019.01)i; G01R 31/385(2019.01)i; G01R 31/387(2019.01)i; G01R 31/396(2019.01)i

According to International Patent Classification (IPC) or to both national classification and IPC

### B. FIELDS SEARCHED

Minimum documentation searched (classification system followed by classification symbols)

IPC: G01R

Documentation searched other than minimum documentation to the extent that such documents are included in the fields searched

Electronic data base consulted during the international search (name of data base and, where practicable, search terms used)

CNTXT; ENTXTC; CNKI; VEN: 可重构, 电池, 内阻, 阻抗, 一致性, 时刻, 电流, 差, 容量, 比, 变化, 率, battery, internal resistance, impedance, consistence, consistency, uniformity, time, current, difference, capacity, rate

### C. DOCUMENTS CONSIDERED TO BE RELEVANT

| Category* | Citation of document, with indication, where appropriate, of the relevant passages | Relevant to claim No. |
| --- | --- | --- |
| PX | CN 118465588 A (YUNCHU NEW ENERGY TECHNOLOGY CO., LTD.) 09 August 2024 (2024-08-09)<br>claims 1-10 | 1-10 |
| X | CN 112180274 A (UNIVERSITY OF SHANGHAI FOR SCIENCE AND TECHNOLOGY) 05 January 2021 (2021-01-05)<br>claims 1-3 and 5-7, description, paragraphs 20-57, and figures 1-2 | 1-10 |
| A | CN 103163467 A (BEIQI FOTON MOTOR CO., LTD.) 19 June 2013 (2013-06-19)<br>entire document | 1-10 |
| A | CN 108427073 A (HUAWEI TECHNOLOGIES CO., LTD.) 21 August 2018 (2018-08-21)<br>entire document | 1-10 |
| A | CN 114325411 A (SHENZHEN LITHIUM SAFETY TECHNOLOGY CO., LTD.) 12 April 2022 (2022-04-12)<br>entire document | 1-10 |
| A | CN 115808637 A (CONTEMPORARY AMPEREX TECHNOLOGY CO., LTD.) 17 March 2023 (2023-03-17)<br>entire document | 1-10 |

☑ Further documents are listed in the continuation of Box C.  ☑ See patent family annex.

| | |
| --- | --- |
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **24 July 2025** | **24 July 2025** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2025/091709** |

**C.      DOCUMENTS CONSIDERED TO BE RELEVANT**

| Category* | Citation of document, with indication, where appropriate, of the relevant passages | Relevant to claim No. |
| --- | --- | --- |
| A | JP 2006250905 A (FUJI HEAVY INDUSTRIES LTD.) 21 September 2006 (2006-09-21) entire document | 1-10 |

Form PCT/ISA/210 (second sheet) (July 2022)

**INTERNATIONAL SEARCH REPORT**
Information on patent family members

International application No.

**PCT/CN2025/091709**

| Patent document cited in search report | | | Publication date (day/month/year) | Patent family member(s) | | | Publication date (day/month/year) |
|---|---|---|---|---|---|---|---|
| CN | 118465588 | A | 09 August 2024 | None | | | |
| CN | 112180274 | A | 05 January 2021 | None | | | |
| CN | 103163467 | A | 19 June 2013 | None | | | |
| CN | 108427073 | A | 21 August 2018 | None | | | |
| CN | 114325411 | A | 12 April 2022 | None | | | |
| CN | 115808637 | A | 17 March 2023 | None | | | |
| JP | 2006250905 | A | 21 September 2006 | JP | 4570991 | B2 | 27 October 2010 |

Form PCT/ISA/210 (patent family annex) (July 2022)